(19) Europäisches Patentamt
European Patent Office
Office européen des brevets

(11) **EP 3 357 090 B1**

(12) **EUROPEAN PATENT SPECIFICATION**

(45) Date of publication and mention
of the grant of the patent:
**17.06.2020 Bulletin 2020/25**

(21) Application number: **15771590.5**

(22) Date of filing: **29.09.2015**

(51) Int Cl.:
***H01L 27/02*** *(2006.01)*    ***H02H 9/04*** *(2006.01)*

(86) International application number:
**PCT/EP2015/072449**

(87) International publication number:
**WO 2017/054849 (06.04.2017 Gazette 2017/14)**

(54) **ELECTROSTATIC DISCHARGE PROTECTION DEVICE AND CIRCUIT APPARATUS**

VORRICHTUNG ZUM SCHUTZ VOR ELEKTROSTATISCHER ENTLADUNG UND SCHALTVORRICHTUNG

DISPOSITIF DE PROTECTION CONTRE LES DÉCHARGES ÉLECTROSTATIQUES ET APPAREIL DE CIRCUIT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**08.08.2018 Bulletin 2018/32**

(73) Proprietor: **TDK Corporation Tokyo 108-0023 (JP)**

(72) Inventors:
• **ZOU, Lei
2300 København S (DK)**
• **ROCCA, Gino
1561 Copenhagen (DK)**

(74) Representative: **Epping - Hermann - Fischer Patentanwaltsgesellschaft mbH Schloßschmidstraße 5 80639 München (DE)**

(56) References cited:
**US-A1- 2003 076 639      US-A1- 2005 237 681
US-A1- 2007 285 854      US-A1- 2009 197 377
US-A1- 2010 149 701      US-A1- 2011 317 319
US-A1- 2013 100 561**

**Description**

The invention relates to an electrostatic discharge (ESD) protection device. Furthermore, the invention relates to a circuit apparatus comprising the ESD protection device and a programmable device.

In order to prevent an integrated circuit (IC) or an application specific integrated circuit (ASIC) from overvoltage ESD damage, ESD overvoltage protection circuits are usually used. For ESD overvoltage protection mainly a diode-clamping ESD protection circuit, for instance with one diode from pad to rail power supply and one diode from ground to pad, is used which limits any voltage higher than the rail power supply or below ground.

New applications require integration of one-time programming (OTP) circuits into ASICs. A programming voltage of the one-time programming circuit can be in the range of 6-8V volt level. For instance, in a microelectromechanical systems (MEMS) microphone ASICs, during a calibration operation, a high-voltage pad is used for one-time programming, which also has to be ESD-protected.

US 2009/0135532 A1 discloses an electrostatic discharge (ESD) protection circuit. A transistor is coupled between a node and a ground, and has a gate coupled to the ground. A diode chain is coupled between the node and a pad, and comprises a plurality of first diodes connected in series, wherein the first diode is coupled in a forward conduction direction from the pad to the node. A second diode is coupled between the node and the pad, and the second diode is coupled in a forward conduction direction from the node to the pad.

US 2013/100561 A1 discloses a circuit providing protection against electrostatic discharge (ESD). A shunt device is controlled to provide a current bypass upon the occurrence of an ESD event. A trigger circuit controls operation of the shunt device and includes an inverter and a hysteresis means to prevent oscillation of the trigger circuit. A reference is used to trigger the control circuit and has a time constant associated with it to distinguish between power up events and ESD events.

US 2010/149701 A1 discloses a method and integrated circuit rendering a shunt structure non-conductive during a power up event or noise event and in addition, during an electrostatic discharge event, keeps the shunt structure conductive for a period of time to discharge electrostatic energy through the shunt structure. In one example, a shunt structure, such as a transistor, is interposed between a power node and a ground node.

US 2009/197377 A1 discloses a selective stress memorization technique in which the creation of tensile strain may be accomplished without additional photolithography steps by using an implantation mask or any other mask required during a standard manufacturing flow, or by providing a patterned cap layer for a strained re-crystallization of respective drain and source areas.

US 2011/317319 A1 discloses an ESD (Electrostatic Discharge, ESD) protection circuit including a voltage-divider generating circuit, a decision circuit, and a switching circuit. The voltage-divider generating circuit outputs a first voltage and a second voltage according to an input voltage. The decision circuit is coupled to the voltage-divider generating circuit and receives the first voltage and the second voltage. The decision circuit outputs an output voltage according to the first voltage and the second voltage. The switching circuit is coupled to the decision circuit and is either turned on or turned off according to the output voltage. The transient voltages of the first and the second voltage are different.

US 2005/237681 A1 discloses an ESD protection circuit including a stacked NMOS transistor pair coupled between a pad and a negative voltage supply, with a first transistor's drain connected to the pad and a second transistor's source connected to the negative power supply.

US 2007/285854 A1 discloses an improved ESD protection device, integrated circuit and method for programmably altering a sensitivity of the ESD protection. More specifically, an active shunt ESD protection device is provided with an improved trigger circuit design.

US 2003/076639 A1 discloses an ESD protection circuit suitable for application to an IC. The ESD protection circuit includes a primary discharging component and an ESD detection circuit.

It is an object of the present invention to provide an electrostatic discharge (ESD) protection device and a circuit apparatus comprising the ESD protection device allowing for a reliable ESD protection, in particular allowing for a reliable ESD protection under a normal and a programming operation mode.

This object is achieved by the features of the independent claims. Advantageous embodiments of the invention are given in the sub-claims.

According to a first aspect, the invention is distinguished by a circuit apparatus comprising a programmable device and an electrostatic discharge, ESD, protection device. The circuit apparatus comprises a rail power supply for power supply of the circuit apparatus. The programmable device comprises a high voltage supply terminal for providing high-voltage pulses for programming the programmable device and the ESD protection device is coupled to the high voltage supply terminal of the programmable device. The ESD protection device comprises a detection circuit, a control circuit and a transistor. The detection circuit is arranged and configured to distinguish between a positive ESD event and a high-voltage rising pad pulse on the high voltage supply terminal. The control circuit is configured to provide a control signal on its output dependent on a detection output signal of the detection circuit, and the transistor is coupled to a reference potential terminal and a high voltage supply terminal, and a control input of the transistor is coupled to the output of the control circuit.

Advantageously the ESD protection device is cost-effective in terms of chip area and can be fully integrated in a submicron CMOS IC or ASIC. There is no need for a diode, in particular an integrated diode. An ESD protection with robust ESD performance for high voltage applications and with no gate oxide reliability concerns can be reached.

Preferably the transistor is arranged and configured such that in an on-state of the transistor it provides a low impedance path from the high voltage supply terminal to the reference potential terminal, in particular to a ground potential for diverting an ESD discharge current away from the circuit to be protected, i. e. the programmable device. An operation region of the transistor is well defined. The transistor can comprise only one low-voltage transistor and/or one medium-voltage transistor and/or one high-voltage transistor.

The ESD protection device is able to steer both positive and negative ESD pulses away from the circuit being protected. No additional transistors or diodes are necessary.

The usage of the threshold detection circuit allows for an easy implementation of the detection circuit and a cost-effective production of the ESD protection device.

According to an embodiment of the first aspect, the ESD protection device comprises a capacitor circuit for AC-coupling or high pass coupling the high voltage supply terminal to an input of the detection circuit.

According to a further embodiment of the first aspect, the threshold of the detection circuit is configurable. This allows for a flexible adjustment to the requirements of the high voltage application.

According to a further embodiment of the first aspect, the threshold of the detection circuit comprises a comparator. This allows for an easy implementation of the detection circuit and a cost-effective production of the ESD protection device.

According to a further embodiment of the first aspect, the comparator comprises a voltage divider and a first inverter, wherein the voltage divider is connected in series with the capacitor circuit and an input of the first inverter is coupled to the voltage divider for tapping a partial voltage of the voltage divider.

According to a further embodiment of the first aspect, the detection circuit comprises only transistors as active components. This allows for an easy implementation of the detection circuit and a cost-effective production of the ESD protection device. In particular no diodes are used.

According to a further embodiment of the first aspect, the control circuit comprises a second inverter. Thus, the control circuit allows for transforming the output signal of the detection circuit in an appropriate control signal for the transistor.

According to a further embodiment of the first aspect, the transistor comprises two low voltage n-channel metal-oxide-semiconductor field-effect transistors NMOS_1, NMOS_2 arranged in series. This allows for applying a higher voltage on the high voltage supply terminal.

According to a further embodiment of the first aspect, the transistor comprises two low voltage n-channel metal-oxide-semiconductor field-effect transistors arranged in series, wherein the respective NMOS transistors are each arranged in a deep N-well. This allows for applying a higher voltage on the high voltage supply terminal and a reduced early reverse breakdown risk of a parasitic diode formed by a drain of the LV NMOS-transistor connected to the high voltage supply terminal and a common substrate.

According to a further embodiment of the first aspect, the transistor comprises a high voltage n-channel metal-oxide-semiconductor field-effect transistor comprising a high voltage N-well and a P-well.

Further features, refinements and expediencies become apparent from the following description of the exemplary embodiments in connection with the figures. These are as follows:

Figure 1 a block diagram of a circuit apparatus comprising an electrostatic discharge (ESD) protection device,

Figure 2 an exemplary schematic diagram of the ESD protection device,

Figure 3 a device cross-sectional view of a first embodiment of a transistor,

Figure 4 a device cross-sectional view of a second embodiment of the transistor and

Figure 5 a device cross-sectional view of a third embodiment of the transistor.

Like elements, elements of the same kind and identically acting elements may be provided with the same reference numerals in the figures.

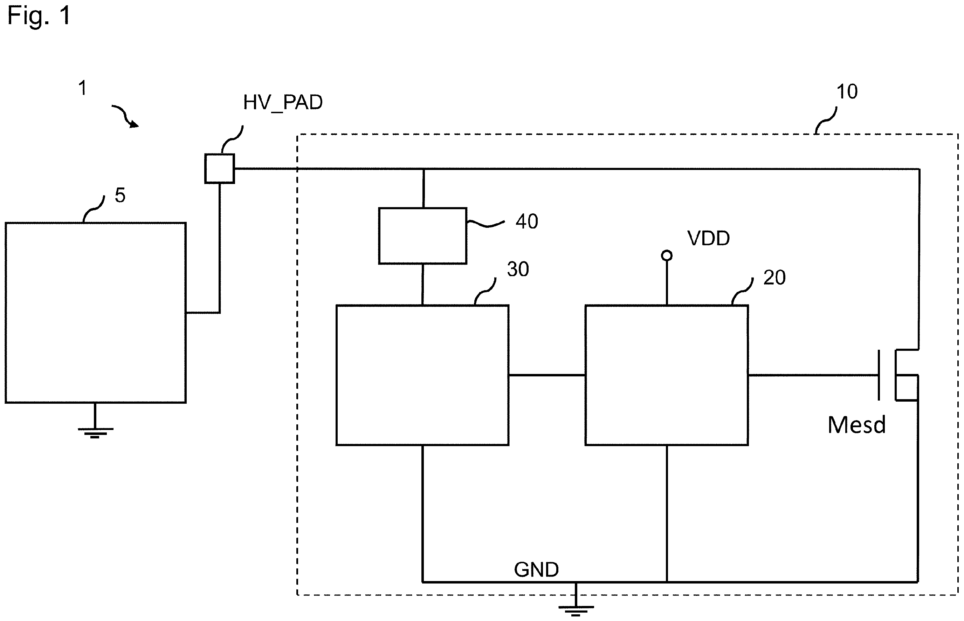

Figure 1 shows a block diagram of a circuit apparatus 1 comprising an electrostatic discharge (ESD) protection device 10 and a circuit 5 to be protected. The circuit 5 to be protected may comprise a programmable device, for instance a one-time programmable memory.

The ESD protection device 10 is coupled to a high voltage supply terminal HV_PAD of the circuit 5 to be protected. The ESD protection device 10 and the circuit 5 to be protected may be integrated on the same die. The circuit apparatus 1 may be an application specific integrated circuit (ASIC), for example for a microelectromechanical systems application and/or a microphone application.

The ESD protection device 10 comprises a transistor Mesd coupled to a reference potential terminal GND and the high voltage supply terminal HV_PAD. Preferably the reference potential is a ground potential.

Furthermore the ESD protection device 10 comprises a control circuit 20 for the transistor Mesd. An output of the control circuit 20 is coupled to a control input of the transistor Mesd.

The ESD protection device 10 comprises a detection circuit 30 configured to distinguish between a positive ESD event and a high-voltage rising pad pulse on the high voltage supply terminal HV_PAD. An output of the detection circuit 30 is coupled to an input of the control circuit 20.

The detection circuit 30 may comprise a threshold detection circuit 30 with a configurable voltage threshold. The threshold detection circuit 30 may be configured to detect a voltage signal at the high voltage supply terminal HV_PAD once it exceeds the selected voltage threshold and to provide a corresponding trigger signal on its output.

Preferably the voltage threshold is set higher than a required high-voltage pad pulse, for example higher than a required high-voltage pad pulse for the programming of the programmable device.

During an ESD event the control circuit 20 activates the transistor Mesd by providing an appropriate control signal at the control input of the transistor Mesd, in particular at a gate of the transistor Mesd, such that the transistor Mesd turns on thus providing a low impedance path between the high voltage supply terminal HV_Pad and the reference potential terminal GND and diverting an ESD discharge current away from the circuit 5 to be protected.

The ESD protection device 10 may comprise a capacitor circuit 40 for AC coupling or high pass coupling an input of the detection circuit 30 with the high voltage supply terminal HV_PAD.

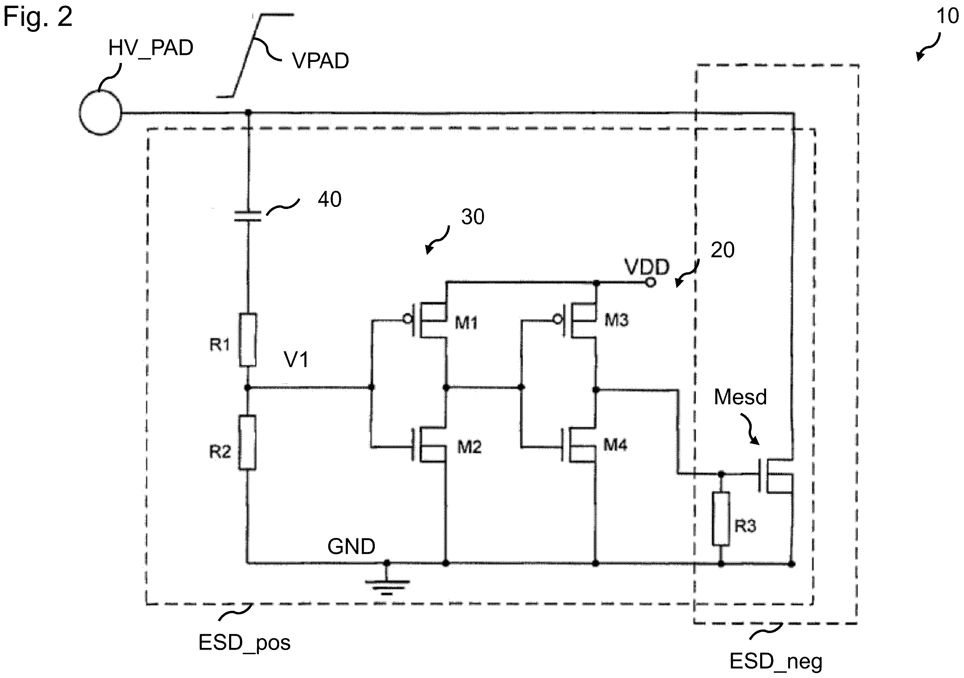

Figure 2 shows an exemplary schematic diagram of the ESD protection device 10.

The detection circuit 30 comprises, for instance, a voltage divider, for example a resistor chain with a first resistor R1 and a second resistor R2, and a first inverter. The voltage divider is connected in series with the capacitor circuit 40 across the reference potential terminal GND and the high voltage supply terminal HV_PAD. An input of the first inverter is coupled to the voltage divider such that, by a voltage division, an input voltage of the first inverter is given according equation (1) as

$$V1=VPAD \ [R2/(R1 + R2)] \quad eq. \ (1)$$

wherein VPAD is the voltage level at the high voltage supply terminal HV_PAD.

The first inverter may comprise a first transistor and a second transistor. The first transistor may be an NMOS transistor and the second transistor may be a PMOS transistor. The gates of the first transistor and second transistor may be at the same bias, which means that they are always in a complementary state.

The control circuit 20 is configured to transform the output signal of the detection circuit 30 into an appropriate control signal for the transistor Mesd. The control circuit 20 may comprise a second inverter. The second inverter may comprise also an n-channel metal-oxide-semiconductor field-effect transistor and a p-channel metal-oxide-semiconductor field-effect transistor.

In normal operation the input voltage V1 of the first inverter is lower than a transition voltage of the first inverter, which means that the first inverter outputs a high signal and the second inverter of the control circuit 20 outputs a low signal. The transistor Mesd is in an off-state.

When the input voltage V1 of the inverter exceeds the transition voltage of the first inverter, the first inverter outputs a low signal and the second inverter outputs a high signal. As in this case the gate of the transistor Mesd is pulled high to a supply voltage VDD, such that the transistor Mesd turns on and shunts the high voltage supply terminal HV_PAD to ground.

The voltage threshold of the detection circuit 30 may be given by equation (2)

$$Vesd = Vtrans*(R1 + R2)/R2$$

wherein Vesd is the voltage threshold and Vtrans is the transition voltage of the first inverter. The voltage threshold of the detection circuit 30 may be configurable by using for instance one or more tunable resistors for the voltage divider.

The transition voltage of the first inverter may be half the supply voltage of the first inverter, and the resistors R1, R2 of the voltage divider may be rated to adjust the voltage threshold. During operation of the circuit apparatus 1 the voltage level at the high voltage supply terminal HV_PAD is compared with the voltage threshold and determines the on/off state of the transistor Mesd.

Assuming a rail power supply of the circuit apparatus 1, in particular the rail power supply of the ASIC, is 3.6 V and the required high voltage rising pad pulse is 6 V. The voltage threshold may be selected to be 7 V where the positive ESD protection starts triggering.

When the voltage level VPAD on the high voltage supply terminal HV_PAD is lower than the voltage threshold of the detection circuit 30, so that the input voltage V1 of the first inverter is below the transition voltage of the first inverter and the transistor Mesd remains in the off-state. When the voltage level VPAD on the high voltage supply terminal HV_PAD is equal to or higher than the voltage threshold of the detection circuit 30, so that the input voltage V1 of the first inverter is above the transition voltage of the first inverter and the transistor Mesd is in the on-state.

As a result, the ESD protection device 10 can distinguish between a positive ESD event and a required high voltage rising pad pulse. Therefore, the ESD protection device 10 does not falsely trigger the transistor Mesd, but only when a positive or negative ESD event occurs.

The ESD protection device 10 is able to steer both positive and negative ESD pulses away from the circuit 5 being protected. The negative ESD protection is triggered when a falling voltage at the high-voltage supply terminal is lower than the reference potential, in particular the ground potential, and a low impedance path is built between the high-voltage supply terminal and the reference potential terminal GND. The ESD protection device 10 comprises a positive ESD protection part ESD_pos and negative ESD protection part ESD_neg. All circuit components of the ESD protection device 10 are used for positive ESD protection and only a resistor R3 of the control circuit 20 and the transistor Mesd are used for negative ESD protection. Thus, the negative ESD protection part ESD_neg reuses components of the positive ESD protection part ESD_pos. No additional transistors or diodes are necessary.

During a negative ESD event, the transistor Mesd is internal ON by means of its drain-source PN junction conduction. The resistor R3 is optional. The Resistor R3 is used to set a ground potential of the gate of transistor Mesd at initial condition so that the transistor Mesd can be off even no control signal is available.

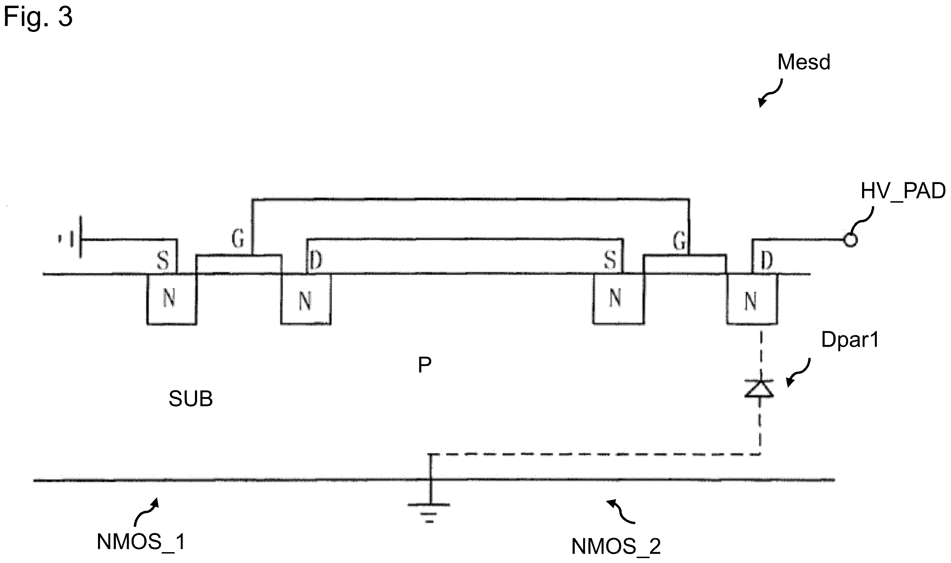

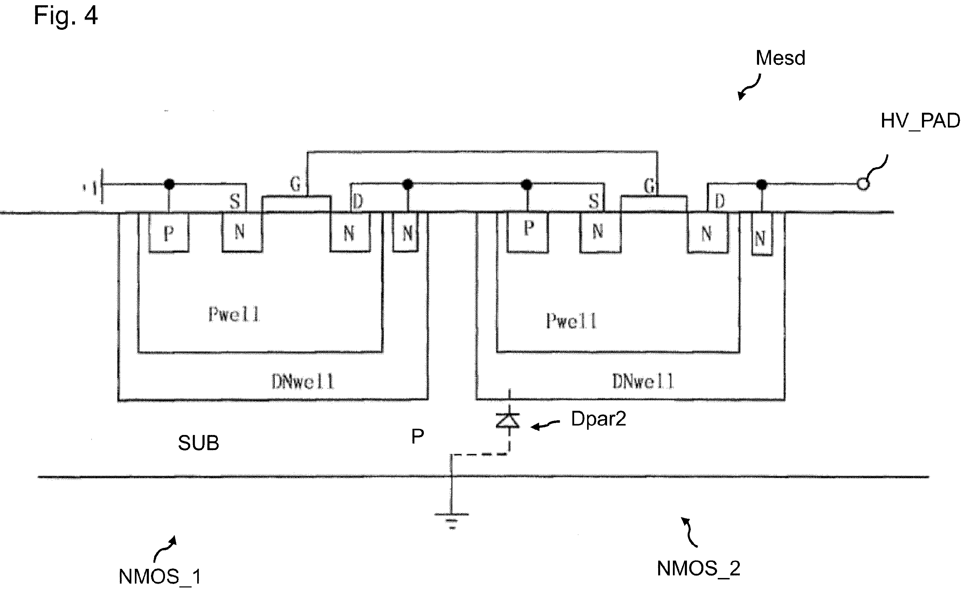

Figure 3 shows a device cross-sectional view of a first embodiment of the transistor Mesd. The transistor Mesd comprises two low voltage n-channel metal-oxide-semiconductor field-effect transistors (LV NMOS-transistors) NMOS_1, NMOS_2 arranged in series. In Figure 4 a doping of a source S, drain D and gate G of the LV NMOS-transistors NMOS_1, NMOS_2 is shown. A transistor substrate SUB is p-doped. This allows for a higher voltage on the high voltage supply terminal HV_PAD.

Alternatively, the transistor Mesd may comprise two medium voltage n-channel metal-oxide-semiconductor field-effect transistors (MV NMOS-transistors) arranged in series.

For avoiding an early reverse breakdown risk of a parasitic diode Dpar1 when applying a high voltage on the high voltage supply terminal HV_PAD the transistor Mesd may be further improved.

The parasitic diode Dpar 1 may be formed by a drain D of the LV NMOS-transistor NMOS_2 connected to the high voltage supply terminal HV_PAD and a common substrate SUB of the LV NMOS-transistors NMOS_1, NMOS_2. The early reverse breakdown risk of the parasitic diode results from thin N-channel doping dimensions in a drain area of the LV-NMOS transistors NMOS_1, NMOS_2.

Figure 4 shows a device cross-sectional view of a second embodiment of the transistor Mesd. The transistor Mesd comprises two low voltage n-channel metal-oxide-semiconductor field-effect transistors NMOS_1, NMOS_2 arranged in series, wherein the respective NMOS transistors are each arranged in a deep N-well. The deep N-wells may be used to isolate the respective NMOS transistors from the substrate SUB of the other NMOS transistors.

Alternatively the transistor Mesd may comprise two medium voltage n-channel metal-oxide-semiconductor field-effect transistors arranged (MV-NMOS) in series, wherein the respective NMOS transistors are each arranged in a deep N-well.

In this case a qualified parasitic diode Dpar2 is formed by the deep N-well of one NMOS-transistor and the substrate SUB. The parasitic diode Dpar2 is a qualified diode due to the significant PN junction dimension of this parasitic diode Dpar2. Therefore, an early reverse breakdown risk of the parasitic diode Dpar2 is reduced.

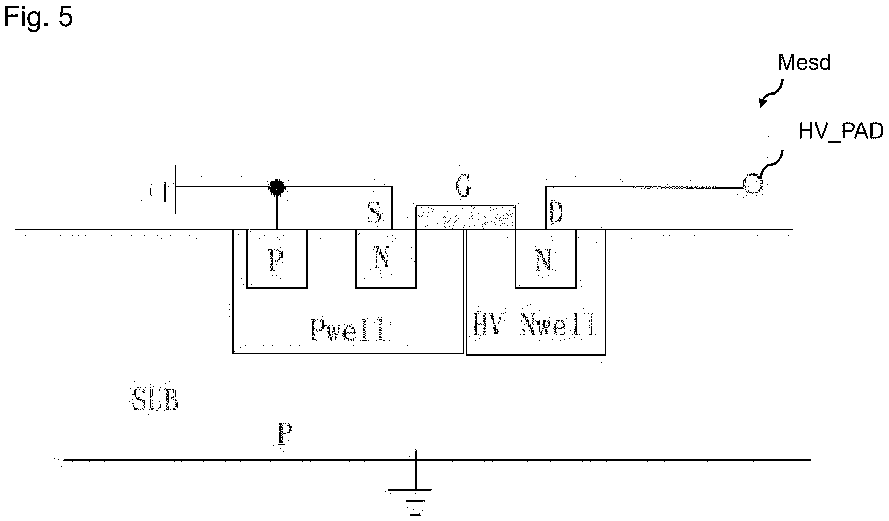

Figure 5 shows a device cross-sectional view of a third embodiment of the transistor Mesd. The transistor Mesd comprises a high voltage n-channel metal-oxide-semiconductor field-effect transistors (HV NMOS). The NMOS transistor is arranged in the substrate SUB. On top of the substrate SUB, a high voltage N-well and a P-well are arranged. A maximum drain-source voltage of the HV N-MMOS transistor may be 16 V. Accordingly the high voltage pad pulse can be up to 16 V.

Reference numerals

| | |
|---|---|
| 1 | circuit apparatus |
| 5 | circuit to be protected |
| 10 | ESD protection device |

| | |
|---|---|
| 20 | control circuit |
| 30 | detection circuit |
| 40 | capacitor circuit |
| D | drain |
| DPAR1, DPAR2 | parasitic diode |
| ESD_neg | negative ESD protection part |
| ESD_pos | positive ESD protection part |
| G | gate |
| GND | reference potential terminal |
| HV_PAD | high voltage supply terminal |
| M1, M3 | second transistor |
| M2, M4 | first transistor |
| Mesd | transistor |
| NMOS_1, | low voltage n-channel metal-oxide-semiconductor |
| NMOS_2 | field-effect transistor |
| R1, R2 | first and second resistor |
| R3 | resistor of the control circuit |
| S | source |
| SUB | substrate |
| V1 | input voltage of the detection circuit |
| VDD | supply voltage |
| VPAD | voltage level at the high voltage supply terminal |

**Claims**

1. Circuit apparatus (1) comprising a programmable device and an electrostatic discharge, ESD, protection device (10), wherein

   - the circuit apparatus (1) comprises a rail power supply for power supply of the circuit apparatus(1),
   - the programmable device comprises a high voltage supply terminal (HV_PAD) for providing high-voltage pulses for programming the programmable device and the ESD protection device (10) is coupled to the high voltage supply terminal (HV_PAD) of the programmable device and
   - the ESD protection device comprises (10) a detection circuit (30), a control circuit (20) and a transistor (Mesd), wherein

      - - the detection circuit (30) is arranged and configured to distinguish between a positive ESD event and a high-voltage rising pad pulse on the high voltage supply terminal (HV_PAD), wherein the detection circuit (30) comprises a threshold detection circuit configured to detect an ESD event when an input signal of the detection circuit (30) exceeds a given threshold, the threshold being set higher than a required high-voltage pad pulse for programming the programmable device and wherein the
      - - the control circuit (20) is configured to provide a control signal on its output dependent on a detection output signal of the detection circuit (30),
      - - the transistor (Mesd) is coupled to a reference potential terminal (GND) and the high voltage supply terminal (HV_PAD) and a control input of the transistor (Mesd) is coupled to the output of the control circuit (20) .

2. The circuit apparatus (1) according to claim 1, wherein the ESD protection device (10) comprises a capacitor circuit (40) for AC-coupling or high pass coupling the high voltage supply terminal (HV_PAD) to an input of the detection circuit (30).

3. The circuit apparatus (1) according to claim 1, wherein the threshold of the detection circuit (30) is configurable.

4. The circuit apparatus (1) according to any one of claims 1 to 3, wherein the threshold detection circuit comprises a comparator.

5. The circuit apparatus (1) according to claim 4, wherein the comparator comprises a voltage divider and a first inverter, wherein the voltage divider is connected in series with the capacitor circuit (40) and an input of the first inverter is coupled to the voltage divider for tapping a partial voltage of the voltage divider.

6. The circuit apparatus (1) according to any one of claims 1 to 5, wherein the detection circuit (30) comprises only transistors as active components.

7. The circuit apparatus (1) according to any one of claims 1 to 6, wherein the control circuit (20) comprises a second inverter.

8. The circuit apparatus (1) according to any one of claims 1 to 7, wherein the transistor (Mesd) comprises two low voltage n-channel metal-oxide-semiconductor field-effect transistors NMOS_1, NMOS_2 arranged in series.

9. The circuit apparatus (1) according to any one of claims 1 to 7, wherein the transistor (Mesd) comprises two low voltage n-channel metal-oxide-semiconductor field-effect transistors NMOS_1, NMOS_2 arranged in series, wherein the respective NMOS transistors are each arranged in a deep N-well.

10. The circuit apparatus (1) according to any one of claims 1 to 7, wherein the transistor (Mesd) comprises a high voltage n-channel metal-oxide-semiconductor field-effect transistor comprising a high voltage N-well and a P-well.

**Patentansprüche**

1. Schaltungsvorrichtung (1), umfassend eine programmierbare Vorrichtung und eine Vorrichtung (10) zum Schutz vor elektrostatischer Entladung (ESD), wobei

- die Schaltungsvorrichtung (1) eine Stromversorgungsschiene für die Stromversorgung der Schaltungsvorrichtung (1) umfasst,
- die programmierbare Vorrichtung einen Hochspannungsversorgungsanschluss (HV_PAD) zum Bereitstellen von Hochspannungsimpulsen zum Programmieren der programmierbaren Vorrichtung umfasst und die ESD-Schutzvorrichtung (10) mit dem Hochspannungsversorgungsanschluss (HV_PAD) der programmierbaren Vorrichtung gekoppelt ist, und
- die ESD-Schutzvorrichtung (10) eine Detektionsschaltung (30), eine Steuerschaltung (20) und einen Transistor (Mesd) umfasst, wobei

- - die Detektionsschaltung (30) dazu angeordnet und eingerichtet ist, zwischen einem positiven elektrostatischer Entladungsereignis und einem Hochspannungs-Kontaktflächen-Anstiegsimpuls am Hochspannungsversorgungsanschluss (HV_PAD) zu unterscheiden, wobei die Detektionsschaltung (30) eine Schwellenwert-Detektionsschaltung umfasst, die dazu eingerichtet ist, ein ESD-Ereignis zu erkennen, wenn ein Eingangssignal der Detektionsschaltung (30) einen gegebenen Schwellenwert überschreitet, wobei der Schwellenwert höher als ein zum Programmieren der programmierbaren Vorrichtung erforderlicher Hochspannungskontaktflächenimpuls eingestellt ist, und wobei
- - die Steuerschaltung (20) dazu eingerichtet ist, ein Steuersignal an ihrem Ausgang bereitzustellen, das von einem Detektionsausgangssignal der Detektionsschaltung (30) abhängt,
- - der Transistor (Mesd) mit einem Bezugspotenzialanschluss (GND) und dem Hochspannungsversorgungsanschluss (HV_PAD) gekoppelt ist und ein Steuereingang des Transistors (Mesd) mit dem Ausgang der Steuerschaltung (20) gekoppelt ist.

2. Schaltungsvorrichtung (1) nach Anspruch 1, wobei die ESD-Schutzvorrichtung (10) eine Kondensatorschaltung (40) für eine Wechselspannungskopplung oder Hochpasskopplung des Hochspannungsversorgungsanschlusses (HV_PAD) mit einem Eingang der Detektionsschaltung (30) umfasst.

3. Schaltungsvorrichtung (1) nach Anspruch 1, wobei der Schwellenwert der Detektionsschaltung (30) konfigurierbar ist.

4. Schaltungsvorrichtung (1) nach einem der Ansprüche 1 bis 3, wobei die Schwellenwert-Detektionsschaltung einen Komparator umfasst.

5. Schaltungsvorrichtung (1) nach Anspruch 4, wobei der Komparator einen Spannungsteiler und einen ersten Inverter umfasst, wobei der Spannungsteiler mit der Kondensatorschaltung (40) in Reihe geschaltet ist und ein Eingang des ersten Inverters zum Abgreifen einer Teilspannung des Spannungsteilers mit dem Spannungsteiler gekoppelt ist.

**6.** Schaltungsvorrichtung (1) nach einem der Ansprüche 1 bis 5, wobei die Detektionsschaltung (30) nur Transistoren als aktive Bauelemente umfasst.

**7.** Schaltungsvorrichtung (1) nach einem der Ansprüche 1 bis 6, wobei die Steuerschaltung (20) einen zweiten Inverter umfasst.

**8.** Schaltungsvorrichtung (1) nach einem der Ansprüche 1 bis 7, wobei der Transistor (Mesd) zwei in Reihe geschaltete Niederspannungs-n-Kanal-Metall-Oxid-Halbleiter-Feldeffekttransistoren (NMOS_1, NMOS_2) umfasst.

**9.** Schaltungsvorrichtung (1) nach einem der Ansprüche 1 bis 7, wobei der Transistor (Mesd) zwei in Reihe geschaltete Niederspannungs-n-Kanal-Metall-Oxid-Halbleiter-Feldeffekttransistoren (NMOS_1, NMOS_2) umfasst, wobei die entsprechenden NMOS-Transistoren jeweils in einer tiefen n-Wanne angeordnet sind.

**10.** Schaltungsvorrichtung (1) nach einem der Ansprüche 1 bis 7, wobei der Transistor (Mesd) einen Hochspannungs-n-Kanal-Metall-Oxid-Halbleiter-Feldeffekttransistor umfasst, der eine Hochspannungs-n-Wanne und eine p-Wanne umfasst.

**Revendications**

**1.** Appareil à circuit (1) comprenant un dispositif programmable et un dispositif de protection contre les décharges électrostatiques, ESD (10), dans lequel

- l'appareil à circuit (1) comprend un rail d'alimentation électrique pour l'alimentation électrique de l'appareil à circuit (1),
- le dispositif programmable comprend une borne d'alimentation haute tension (HV_PAD) pour fournir des impulsions à haute tension pour programmer le dispositif programmable et le dispositif de protection ESD (10) est couplé à la borne d'alimentation haute tension (HV_PAD) du dispositif programmable et
- le dispositif de protection ESD comprend (10) un circuit de détection (30), un circuit de commande (20) et un transistor (Mesd), dans lequel

- - le circuit de détection (30) est agencé et configuré pour faire la distinction entre un événement ESD positif et une impulsion montante à un plot de haute tension sur la borne d'alimentation haute tension (HV_PAD), dans lequel le circuit de détection (30) comprend un circuit de détection de seuil configuré pour détecter un événement ESD lorsqu'un signal d'entrée du circuit de détection (30) dépasse un seuil donné, le seuil étant établi plus haut qu'une impulsion à le plot haute tension requise pour programmer le dispositif programmable et dans lequel le
- - le circuit de commande (20) est configuré pour fournir un signal de commande sur sa sortie en fonction d'un signal de sortie de détection du circuit de détection (30),
- - le transistor (Mesd) est couplé à une borne de potentiel de référence (GND) et à la borne d'alimentation haute tension (HV_PAD) et une entrée de commande du transistor (Mesd) est couplée à la sortie du circuit de commande (20).

**2.** Appareil à circuit (1) selon la revendication 1, dans lequel le dispositif de protection ESD (10) comprend un circuit de condensateur (40) pour un couplage en CA ou un couplage passe-haut de la borne d'alimentation haute tension (HV_PAD) à une entrée du circuit de détection (30).

**3.** Appareil à circuit (1) selon la revendication 1, dans lequel le seuil du circuit de détection (30) est configurable.

**4.** Appareil à circuit (1) selon l'une quelconque des revendications 1 à 3, dans lequel le circuit de détection de seuil comprend un comparateur.

**5.** Appareil à circuit (1) selon la revendication 4, dans lequel le comparateur comprend un diviseur de tension et un premier onduleur, dans lequel le diviseur de tension est connecté en série au circuit de condensateur (40) et une entrée du premier onduleur est couplée au diviseur de tension pour prélever une tension partielle du diviseur de tension.

**6.** Appareil à circuit (1) selon l'une quelconque des revendications 1 à 5, dans lequel le circuit de détection (30) comprend uniquement des transistors en guise de composants actifs.

7. Appareil à circuit (1) selon l'une quelconque des revendications 1 à 6, dans lequel le circuit de commande (20) comprend un deuxième onduleur.

8. Appareil à circuit (1) selon l'une quelconque des revendications 1 à 7, dans lequel le transistor (Mesd) comprend deux transistors à effet de champ métal-oxyde-semiconducteur de canal n basse tension (NMOS_1, NMOS_2) agencés en série.

9. Appareil à circuit (1) selon l'une quelconque des revendications 1 à 7, dans lequel le transistor (Mesd) comprend deux transistors à effet de champ métal-oxyde-semiconducteur à canal n basse tension (NMOS_1, NMOS_2) agencés en série, dans lequel les transistors NMOS respectifs sont chacun agencés dans un puits N profond.

10. Appareil à circuit (1) selon l'une quelconque des revendications 1 à 7, dans lequel le transistor (Mesd) comprend un transistor à effet de champ métal-oxyde-semiconducteur à canal n haute tension comprenant un puits N haute tension et un puits P.

Fig. 1

EP 3 357 090 B1

Fig. 2

EP 3 357 090 B1

EP 3 357 090 B1

Fig. 3

Fig. 4

Mesd

HV_PAD

EP 3 357 090 B1

Fig. 5

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

## Patent documents cited in the description

- US 20090135532 A1
- US 2013100561 A1
- US 2010149701 A1
- US 2009197377 A1
- US 2011317319 A1
- US 2005237681 A1
- US 2007285854 A1
- US 2003076639 A1